# EUROPEAN PATENT SPECIFICATION

(11) **EP 3 244 116 B1**
(45) Date of publication and mention of the grant of the patent: **04.09.2019**
(21) Application number: 16305549.4
(22) Date of filing: 11.05.2016
(51) Int. Cl.: F16L 53/37, G01R 31/44, H05B 1/02, H05B 3/42, G01R 31/08

(54) **FAULT DETECTION SYSTEM FOR SUBSEA PIPELINE DIRECT ELECTRICAL HEATING (DEH) CABLE**
FEHLERERKENNUNGSSYSTEM FÜR KABEL ZUR ELEKTRISCHEN DIREKTHEIZUNG (DEH) VON UNTERWASSERPIPELINE
SYSTÈME DE DÉTECTION DE DÉFAILLANCE DE CÂBLE DE CHAUFFAGE ÉLECTRIQUE DIRECT DE PIPELINE SOUS-MARIN

(43) Date of publication of application: 15.11.2017
(73) Proprietor: Nexans, 92400 Courbevoie (FR)
(72) Inventor: SANGAR, Robin, 1445 DROBAK (NO); IVERSEN, Oyvind, 1406 SKI (NO)
(74) Representative: Feray, Valérie

(56) References cited:
- WO-A1-2013/113627
- WO-A2-2007/096775
- US-A1- 2001 005 646

## Description

### FIELD OF THE INVENTION

This invention relates to a fault detection system for subsea pipeline direct electrical heating (DEH) cable. The invention regards in particular a system for monitoring a DEH cable in order to detect fault in the remote or far end of the cable.

### BACKGROUND OF THE INVENTION

A direct electrical heating (DEH) system is arranged for heating of oil or gas pipelines in order to prevent hydrate and ice formation on the pipeline walls. The pipe is heated by running alternating current (AC) through the steel in the pipe. By use of electrical current, the pipeline is heated to stay above critical temperature in the event of production shut down, low production rates or inadequate temperature in the pipeline. The DEH can be turned on when required.

In order to supply current to such a heating system the common practice is to install a power supply cable that is connected to a supply cable as a so called "piggyback" cable. This piggyback cable is traditionally laid simultaneously with the laying of the pipeline. More specifically such a cable is strapped to the pipeline during installation thereof. The DEH piggyback cable conducts current from the platform end of the pipeline to the well (far end). At the well, the piggyback cable is connected to the pipeline and the current returns to the platform end trough the steel in the pipeline in parallel with the sea water. The piggyback cable is commonly placed as close to the thermally insulated pipeline as possible, as this yields optimum DEH system efficiency.

This invention is intended to provide a means of fault detection in particular for the remote part of a high voltage cable when used as a DEH piggyback cable. The piggyback cable is intentionally connected to ground at its remote end, a fact that makes conventional detection of faults in that region extremely difficult. The piggyback cable has a linearly decreasing voltage, from an input value at its power in-feed end to zero at the grounded, remote end. Consequently, the electric field stress on the cable insulation also decreases linearly, from a normal operating stress at the power in-feed end to zero at the remote end.

A cable fault in the remote region may be initiated by a mechanical damage, e.g. a cut extending through the outer sheath and the insulation system, thus exposing the copper conductor to seawater. As the conductor is connected to ground at the remote end, the fault will shunt its remaining length from fault location to grounded end. The corresponding change in conductor current will be minute and extremely difficult to detect at the opposite end of the piggyback cable. In most practical installations, the current measurement will be done even further upstream, making small changes even harder to detect. The conductor current in a DEH system is typically larger than 600 A, and a fault current of 10 A (through the physical fault) will translate into a far smaller change at the in-feed end (due to phase shifting). Even with the best available current measuring equipment, cable faults near the remote end will therefore pass on undetected.

Conventional systems for protection of DEH cables comprise impedance protection and differential current protection. Both protection systems work by measuring electrical quantities at the in-feed end of the DEH system. Differential protection also requires measured current at the remote (subsea) end.

A fiber optic sensor is a sensor that uses optical fiber either as the sensing element ("intrinsic sensors"), or as a means of relaying signals from a remote sensor to the electronics that process the signals ("extrinsic sensors"). Fibers have many uses in remote sensing. Depending on the application, fiber may be used because of its small size, or because no electrical power is needed at the remote location, or because many sensors can be multiplexed along the length of a fiber by using light wavelength shift for each sensor, or by sensing the time delay as light passes along the fiber through each sensor. Time delay can be determined using a device such as an optical time-domain reflectometer (OTDR) and wavelength shift can be calculated using an instrument implementing optical frequency domain reflectometry. Optical fiber break detection could provide a means of detecting cable break within the remote end region.

Document WO 2013/113627 A1 discloses a method for detecting a fault in a subsea power cable or in a DEH system.

The publication EP 1 989 525 B1, discloses a fault detection system for subsea pipeline direct electrical heating (DEH) cable by verifying optical continuity in an optical fiber element that is integrated in the piggyback cable, in addition to monitoring the changes in the supplied current from the topside. However, monitoring the changes in the topside current is difficult if the fault is near the remote or far end of the system with sufficient accuracy. The far end (as well as other sections) is covered by using an optical fiber element that is burned off by the wayward current at the fault location, exposing the fiber optic element to the physical fault and are capable of bringing about an optical signal indicating a fault condition.

It is also know to use commonly known analogue current sensors to measure the current in a cable. However, an analogue measuring device will not provide sufficient accuracy due to uncertainties in the measuring device combined with long analogue signal cables back to the platform which influences the readings.

It is an aim of the invention to provide an alternative fault detection system for subsea pipeline direct electrical heating (DEH) cable.

It is also an aim of the invention to provide fault detection system for subsea pipeline direct electrical heating (DEH) cable that provides increased speed and accuracy of measuring signals.

Another aim of the invention is to provide a system for monitoring fault at the far end of the system with sufficient accuracy and reliability.

Yet another aim of the invention is to provide a fault detection system for subsea pipeline direct electrical heating (DEH) cable with simpler installation and commissioning.

### SUMMARY OF THE INVENTION

In the following, the term "far end" is referred to as a distant end, remote end or opposite end of a cable with reference to the in-feed end of the cable.

A current sensor is a device that detects electric current (AC or DC) in a cable, and generates a signal proportional to it. The generated signal could be analog voltage or current or even digital output. It can then be utilized to display the measured current in an ammeter or can be stored for further analysis in a data acquisition system or can be utilized for control purpose.

A fiber optic current sensor (FOCS) is a current sensor for measuring electric current by using a single-ended optical fiber around the current conductor that utilizes the magneto-optic effect (Faraday Effect). The Faraday Effect can be observed when polarized light waves are exposed to a magnetic field. As a result, the waves accumulate a phase difference. In the FOCS system, the right and left circularly polarized light waves travel through the coil of the sensing fiber. At the end of the fiber, they are reflected (and their polarization direction is swapped) and then retrace their optical path to the sensor electronics.

The above aims of the invention are achieved by a fault detection system for a direct electrical heating cable for a subsea pipeline according to claim 1.

The first and second conductors may be a part of a so-called feeder cable or umbilical, the purpose of which is to supply power from a platform down to one or more installations on the sea bed. The cable may comprise several sections, and may include hydraulic tubes and signal cables in addition to power cables.

In one aspect of the invention, at least a first section of the fiber optic cable is incorporated into the DEH cable.

In one aspect of the invention, the first conductor, the second conductor and at least a second section of the fiber optic cable is incorporated into one cable.

In one aspect of the invention, the DEH cable is provided between the second position and the third position.

In one aspect of the invention, the DEH cable is strapped to the pipeline.

In one aspect of the invention, the first position is provided topside, on a floating vessel, structure connected to seabed i.e. not floating but a rigid construction, or on a land based structure.

In one aspect of the invention, the third position is a far end position of the DEH cable.

In one aspect of the invention, the first current sensing device is provided at the first position or between the first and second positions.

### DETAILED DESCRIPTION

Embodiments of the invention will be described in detail below with reference to the enclosed drawings:
Fig. 1 shows schematically the general principles of the present invention;
Fig. 2 shows an enlarged view of the dashed circle of fig. 1, where the far end current sensor is a FOCS sensor;
Fig. 3 shows an alternative aspect of fig. 2, where the far end current sensor is a ACS sensor.

Various objects, features, aspects and advantages of the inventive subject matter will become more apparent from the following detailed description of preferred embodiments, along with the accompanying drawings figures in which the like numerals represents like components.

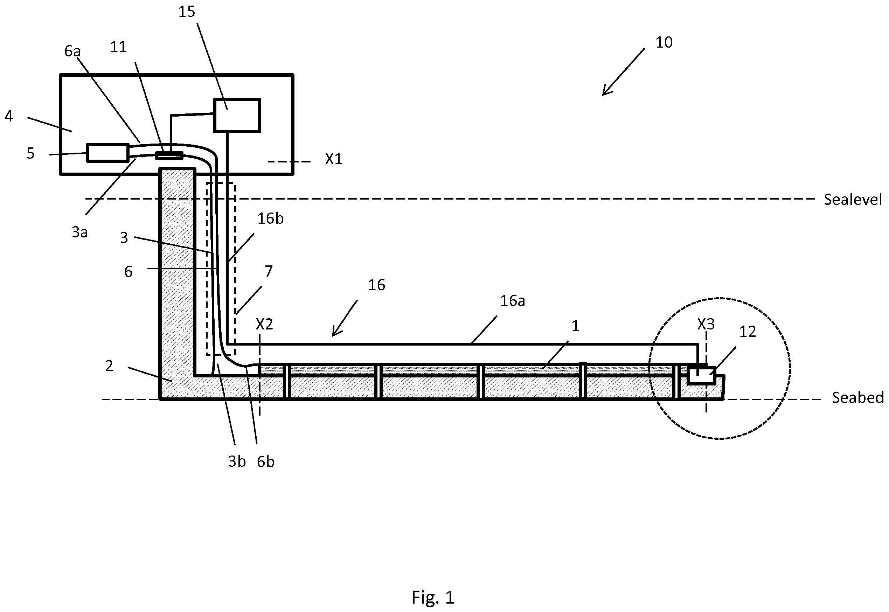

It is now referred to fig. 1, showing a direct electrical heating DEH cable 1 for heating of a subsea oil and/or gas pipeline 2. The subsea pipeline 2 is provided from a first location referred to as position XI, further to a second location referred to as position X2 and then to a third location referred to as position X3.

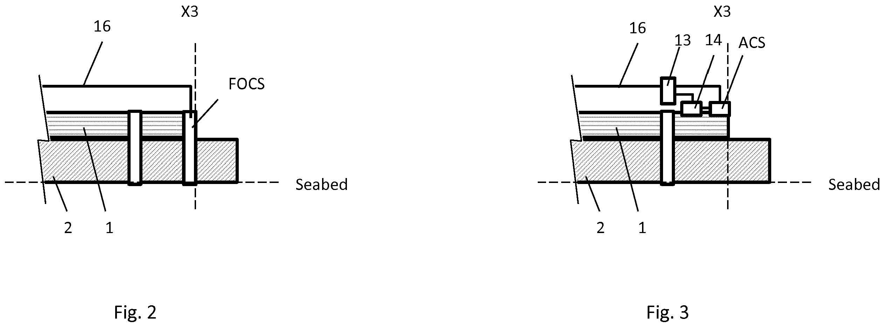

The first position X1 is here provided on a platform or vessel 4, but it may also be provided on a land-based installation. The third position X3 is referred to as the far end of the pipeline 2, where the second position X2 is provided between the first position X1 and the third position X3. As shown in fig. 2, the DEH cable 1 is provided for heating of the pipeline 2 between the second and third positions X2, X3. The DEH cable 1 is typically strapped to the pipeline 2 as a so-called piggyback cable. Accordingly, the second position X2 is considered proximal to the first position XI, while the third position X3 is considered as distal to the first position X1.

At the first position XI, a power supply system 5 is provided for supplying power to the DEH cable 1 via a cable indicated as a dashed box 7.

The cable 7 comprises a first conductor 3 and a second conductor 6. The first conductor 3 has a first end 3a and a second end 3b. The second conductor 6 has a first end 6a and a second end 6b.

The first ends 3a, 6a of the first and second conductors 3, 6 are both connected to the power supply system 5. The second end 3b of the first conductor 3 is connected to the pipeline 2, either at the second position X2 or between the first and second position XI, X2. The second end 6b of the second conductor 6 is connected to the DEH cable 1 at a second position X2 proximal to said first position X1.

The DEH cable 1 is electrically connected to the pipeline 2 at the third position X3 distal to the topside first position X1. Accordingly, the power supply system 5 is supplying current flowing from the first position X1 via the second conductor 6 to the DEH cable 1 at the second position X2, then through the DEH cable 1 to the third position X3, and then back through the pipeline 2 and seawater in parallel to the second position X2. At position X2 the current in pipeline 2 and seawater reunites and returns to the topside first position X1 via the first conductor 3. It would however possible to connect the second end 3b of the first conductor 3 to the pipeline 2 at another location between the second position X2 and the first position X1.

In fig. 1, a fault detection system is generally referred to with reference number 10. The system 10 comprises a first current sensing device 11 configured to provide a signal S1 representative of the current flowing into or out from the power supply system 5. The first current sensor 11 may be provided at the first position X1 or somewhere between the first and second positions XI, X2. In fig. 1, the first current sensor 11 is connected to the first conductor 3.

The system 10 further comprises a second current sensing device 12 configured to provide a signal S2 representative of current in the DEH cable 1 at the third position X3.

The system 10 further comprises a signal processing device 15 configured to compare the signal S2 representing the current at the third position X3 with the signal S1 representing the current into or out from the power supply system 5. The signal processing device 15 is typically a digital signal processor.

The process of raising a warning may comprise to send a warning message, either to a person or to another system monitoring and/or controlling the pipeline 2 and/or DEH cable 1, or to display a warning message on a display etc.

The system 10 further comprises a fiber optic cable 16 connected between the second current sensing device 12 and the signal processing device 15 for transferring the signal provided by the second sensor 12 to the signal processing device 15. Hence, the signal may be transferred from the third position X3 to the first position X1 fast, without reduced signal quality.

The fiber optic cable 16 may be incorporated into the DEH cable 1 from the third position X3 to the second position X2, and may be incorporated into the cable 7 from the second position X2 to the first position X1. In fig. 1, a first section 16a of the fiber optic cable 16 is incorporated into the DEH cable 1 and a second section 16b of the fiber optic cable 16 is incorporated into the cable 7.

The signal processing device 15 may also comprise a converter for converting the optical signal from the fiber optic cable 16 to a signal readable by the signal processing device, typically a digital signal. Moreover, the signal processing device 16 may comprise a converter for converting the signal from the first current sensor 11 to a signal readable by the signal processing device, for example an analogue to digital convert.

The signal processing device 15 will also be configured to raise a warning if the result of the comparison of the signals is indicating that a fault is present. A fault indication may typically be a change in the signal from the second current sensor 12, without any change in the signal from the first current sensor 11. Another fault indication would be that the change in the signal from the second current sensor 12 does not match the modeled result when the signal from the first current sensor 11 is changed.

It is now referred to fig. 2. Here, the second current sensing device 12 is a fiber optic current sensor FOCS provided circumferentially around the DEH cable 1. As the DEH cable 1 is strapped onto the pipeline 2, the FOCS sensor may be provided circumferentially around the DEH cable and the pipeline 2 at the third position X3.

As is mentioned in the introduction above, the FOCS sensor may measure the current in a conductor accurately and reliably. The fiber optic current sensor FOCS is preferably optically connected to the fiber optic cable 16.

It is now referred to fig. 3. Here, the second current sensing device 12 is an analogous current sensor ACS. According to this aspect, the ACS sensor is connected to a signal converter 13 configured to convert a signal from the analogous current sensor ACS to an optical signal supplied to the fiber optic cable 16. The ACS sensor and the signal converter 13 will typically need electrical power. A power converter 14 is therefore connected to the ACS sensor and the signal converter 13. The power converter is configured to convert electromagnetic power from the DEH cable 1 to an electric power supplied to the analogous current sensor ACS and to the signal converter 13. When the DEH cable 1 is supplied with power from the power supply system 5 via cable 3, it will set up an electromagnetic field. At least some parts of the DEH cable 1 may be provided with a sheath to reduce the electromagnetic field, in such a situation this sheath may be removed at the third position X3 to improve the electromagnetic coupling between the DEH cable 1 and the power converter 14.

A main advantage of this invention is that it provides a system for fault detection in a DEH cable by using the benefits of the Optical Fiber cable. The results are increased speed and accuracy of measuring signals together with sufficient reliability.

## Claims

1. Fault detection system (10) for a direct electrical heating (DEH) cable (1) for a subsea pipeline (2), the system comprising:
- a first conductor (3) having a first end (3a) and a second end (3b);
- a second conductor (6) having a first end (6a) and a second end (6b); a first current sensing device (11) and a second current sensing device (12),
where said first ends (3a, 6a) are both connected to a power supply system (5) provided at a first position (X1); where the second end (6b) of the second conductor (6) is in use connected to the DEH cable (1) at a second position (X2) proximal to said first position (X1); where the DEH cable (1) is electrically connected to the pipeline (2) at a third position (X3) distal to the first position (X1); wherein the second end (3b) of the first conductor (3) is in use connected to the pipeline (2), wherein the system (10) comprises a fiber optic cable (16) connected between the second current sensing device (12) and a signal processing device (15) for transferring the signal S2 provided by the second current sensing device (12) to the signal processing device (15) the system (10) also comprising
- its first current sensing device (11) configured to provide a signal S1 representative of the current into or out from the power supply system (5);
- its second current sensing device (12) configured to provide in use a signal S2 representative of the current in the DEH cable (1) at the third position (X3);
- a signal processing device (15) configured to compare the signal S2 representing the current in the DEH cable (1) at the third position (X3) with the signal S1 representing the current into or out from the power supply system **characterized in that**:
said second current sensing device (12) is a fiber optic current sensor (FOCS) provided in use circumferentially around the DEH cable (1), where the fiber optic current sensor (FOCS) is optically connected to the fiber optic cable (16).

2. Installation comprising a DEH cable and a fault detection system according to claim 1, where at least a first section (16a) of the fiber optic cable (16) is incorporated into the DEH cable (1).

3. Installation according to claim 2, where the first conductor (3), the second conductor (6) and at least a second section (16b) of the fiber optic cable (16) is incorporated into one cable (7).

4. Installation according to claims 2, 3 of the above claims, where the DEH cable (1) is provided between the second position (X2) and the third position (X3).

5. Installation according to any one of the above claims 2, 3, 4 where the DEH cable (1) is strapped to the pipeline (2).

6. Installation or fault detection system according to any one of the above claims, where the first position (X1) is provided topside, on a floating vessel, an offshore structure fixed to the seabed or on a land based structure (4).

7. Installation according to claims 2-6, where the third position (X3) is a far end position of the DEH cable (1).

8. Fault detection system or installation according to any one of the above claims, where the first current sensing device (11) is provided at the first position (X1) or between the first and second positions (X1, X2).

## Patentansprüche

1. Fehlererkennungssystem (10) für ein Kabel (1) zur elektrischen Direktheitzung einer Unterwasser-Fernleitung (2), wobei das System umfasst:
- einen ersten Leiter (3) mit einem ersten Ende (3a) und einem zweiten Ende (3b),
- einen zweiten Leiter (6) mit einem ersten Ende (6a) und einem zweiten Ende (6b), ein erstes Strommessgerät (11) und ein zweites Strommessgerät (12),
wobei die ersten Enden (3a, 6a) mit einem in einer ersten Position (X1) vorgesehenen Stromversorgungssystem (5) verbunden sind,
wobei das zweite Ende (6b) des zweiten Leiters (6) im Einsatz mit dem Heizkabel (1) in einer proximal zur ersten Position (X1) liegenden zweiten Position (X2) verbunden ist,
wobei das Heizkabel (1) in einer distal zur ersten Position (X1) liegenden dritten Position (X3) mit der Fernleitung (2) elektrisch verbunden ist,
wobei das zweite Ende (3b) des ersten Leiters (3) im Einsatz mit der Fernleitung (2) verbunden ist, wobei das System (10) umfasst:
einen Lichtwellenleiter (16), der zwischen dem zweiten Strommessgerät (12) und einem Signalverarbeitungsgerät (15) verbunden ist, um das vom zweiten Strommessgerät (12) bereitgestellte Signal S2 an das Signalverarbeitungsgerät (15) zu senden,
wobei das System (10) ferner dessen erstes Strommessgerät (11) umfasst, das derart konfiguriert ist, dass es ein Signal S1 bereitstellt, das für den Strom, der dem Stromversorgungssystem (5) zufließt oder aus diesem abfließt, repräsentativ ist,
wobei dessen zweites Strommessgerät (12) derart konfiguriert ist, dass es im Einsatz ein Signal S2 bereitstellt, das für den Strom im Heizkabel (1) in der dritten Position (X3) repräsentativ ist,
- ein Signalverarbeitungsgerät (15), das derart konfiguriert ist, dass es das Signal S2, das den Strom im Heizkabel (1) in der dritten Position (X3) darstellt, mit dem Signal S1, das den dem Stromversorgungssystem zufließenden oder aus diesem abfließenden Strom darstellt, vergleicht, **dadurch gekennzeichnet, dass**:
wobei das zweite Strommessgerät (12) ein LWL-Stromsensor ist, der im Einsatz in Umfangsrichtung um das Heizkabel (1) herum vorgesehen ist, wobei der LWL-Stromsensor optisch mit dem Lichtwellenleiter (16) verbunden ist.

2. Einrichtung, umfassend ein Heizkabel und ein Fehlererkennungssystem nach Anspruch 1, wobei mindestens ein erster Abschnitt (16a) des Lichtwellenleiters (16) ins Heizkabel (1) eingegliedert ist.

3. Einrichtung nach Anspruch 2, wobei der erste Leiter (3), der zweite Leiter (6) und mindestens ein zweiter Abschnitt (16b) des Lichtwellenleiters (16) in einem Kabel (7) integriert sind.

4. Einrichtung nach den Ansprüchen 2 und 3,
wobei das Heizkabel (1) zwischen der zweiten Position (X2) und der dritten Position (X3) vorgesehen ist.

5. Einrichtung nach einem der Ansprüche 2, 3 und 4, wobei das Heizkabel (1) an der Fernleitung (2) angeschnallt ist.

6. Einrichtung oder Fehlererkennungssystem nach einem der vorstehenden Ansprüche, wobei die erste Position (X1) über der Wasserlinie auf einem schwimmenden Fahrzeug, einer auf dem Meeresboden befestigten Offshore-Anlage oder einer Bodenstruktur (4) vorgesehen ist.

7. Einrichtung nach Anspruch 2 - 6,
wobei die dritte Position (X3) eine äußere Endposition des Heizkabels (1) ist.

8. Fehlererkennungssystem oder Einrichtung nach einem der vorstehenden Ansprüche,
wobei das erste Strommessgerät (11) in der ersten Position (X1) oder zwischen der ersten und zweiten Position (X1, X2) vorgesehen ist.

## Revendications

1. Système de détection de défaillance (10) destiné à un câble de chauffage électrique direct (DEH) (1) de pipeline sous-marin (2), le système comprenant :
- un premier conducteur 3) qui possède une première extrémité (3a) et une seconde extrémité (3b) ;
- un second conducteur (6) qui possède une première extrémité (6a) et une seconde extrémité (6b) ;
un premier dispositif de détection de courant (11) et un second dispositif de détection de courant (12), dans lequel lesdites premières extrémités (3a, 6a) sont reliées à un système d'alimentation électrique (5) prévu à un premier emplacement (X1) ; dans lequel la seconde extrémité (6b) du second conducteur (6) est, pendant l'utilisation, reliée au câble DEH (1) à un second emplacement (X2) proche dudit premier emplacement (X1) ; dans lequel le câble DEH (1) est électriquement relié au pipeline (2) à un troisième emplacement (X3) distal du premier emplacement (X1) ;
dans lequel la seconde extrémité (3b) du premier conducteur (3) est, pendant l'utilisation, reliée au pipeline (2), dans lequel le système (10) comprend un câble à fibre optique (16) relié entre le second dispositif de détection de courant (12) et un dispositif de traitement de signal (15) destiné à transférer le signal S2 fourni par le second dispositif de détection de courant (12) au dispositif de traitement de signal (15), le système (10) comprenant en outre
- son premier dispositif de détection de courant (11) configuré pour fournir un signal S1 représentatif du courant vers ou depuis le système d'alimentation électrique (5) ;
- son second dispositif de détection de courant (12) configuré pour fournir, pendant l'utilisation, un signal S2 représentatif du courant dans le câble DEH (1) au troisième emplacement (X3) ;
- un dispositif de traitement de signal (15) configuré pour comparer le signal S2 qui représente le courant dans le câble DEH (1) au troisième emplacement (X3) avec le signal S1 qui représente le courant vers ou depuis le système d'alimentation électrique, **caractérisé en ce que** :
ledit second dispositif de détection de courant (12) est un détecteur de courant à fibre optique (FOCS) prévu, pendant l'utilisation, de manière circonférentielle autour du câble DEH (1), dans lequel le détecteur de courant à fibre optique (FOCS) est relié optiquement au câble à fibre optique (16).

2. Installation comprenant un câble DEH et un système de détection de défaillance selon la revendication 1, dans lequel au moins une première section (16a) du câble à fibre optique (16) est intégrée au câble DEH (1).

3. Installation selon la revendication 2, dans laquelle le premier conducteur (3), le second conducteur (6) et au moins une seconde section (16b) du câble à fibre optique (16) sont intégrés à un câble (7).

4. Installation selon l'une des revendications 2 ou 3, dans lequel le câble DEH (1) est prévu entre le second emplacement (X2) et le troisième emplacement (X3).

5. Installation selon l'une quelconque des revendications 2, 3 et 4, dans lequel le câble DEH (1) est fixé sur le pipeline (2).

6. Installation ou système de détection de défaillance selon l'une quelconque des revendications précédentes, dans laquelle/lequel le premier emplacement (X1) est prévu sur le dessus, sur un navire flottant, une structure en mer fixée sur le fond marin, ou sur une structure terrestre (4).

7. Installation selon les revendications 2 à 6, dans laquelle le troisième emplacement (X3) est un emplacement éloigné du câble DEH (1).

8. Système de détection de défaillance ou installation selon l'une quelconque des revendications précédentes, dans lequel/laquelle le premier dispositif de détection de courant (11) est prévu au premier emplacement (X1) ou entre le premier et le second emplacements (X1, X2).
